# DEMANDE DE BREVET EUROPEEN

(11) **EP 1 732 119 A2**
(43) Date de publication de la demande: **13.12.2006**
(21) Numéro de dépôt: 06290897.5
(22) Date de dépôt: 01.06.2006
(51) Int. Cl.: H01L 21/60, H01L 21/768

(54) **Réalisation de deux éléments superposés au sein d'un circuit électronique intégré**

(30) Priorité: 09.06.2005 FR 0505880
(71) Demandeur: STMicroelectronics ( Crolles 2) SAS, 38920 Crolles (FR); COMMISSARIAT A L'ENERGIE ATOMIQUE, 75015 Paris (FR)
(72) Inventeur: Bustos, Jessy, 38660 Le Touvet (FR); Thony, Philippe, 38134 Saint Joseph de Rivière (FR); Coronel, Philippe, 38530 Barraux (FR)
(74) Mandataire: Boire, Philippe Maxime Charles

(57) **Abrégé**

Un procédé de réalisation de deux éléments (1a, 4a) superposés au sein d'un circuit électronique intégré permet de réduire ou de supprimer des marges d'alignement autour de ces éléments. Des côtés (12, 13) de l'élément de circuit supérieur (4a) sont définis par des bords de l'élément de circuit inférieur (1a), lors d'une étape d'exposition du circuit à un rayonnement lithographique. D'autres côtés (11a, 11b) de l'élément de circuit supérieur (4a) sont définis par une couche qui atténue une réflexion du rayonnement sur l'élément de circuit inférieur (1a). Le procédé peut être appliqué à une réalisation de connexions électriques.

## Description

La présente invention concerne un procédé de réalisation de deux éléments superposés au sein d'un circuit électronique intégré. Elle concerne aussi un circuit électronique intégré qui comprend des éléments ainsi réalisés.

En particulier, l'invention peut être appliquée à la réalisation d'une connexion électrique au sein d'un circuit électronique intégré.

Un circuit électronique intégré possède usuellement des connexions électriques qui sont disposées au sein de plusieurs niveaux de connexions superposés au dessus de la surface d'un substrat du circuit. Le premier niveau de connexions, à partir de la surface du substrat, correspond à une couche dite de prémétallisation. Les niveaux suivants correspondent à des couches respectives de métallisation. Une connexion électrique peut relier des éléments du circuit parallèlement à la surface du substrat. Elle est alors appelée piste. Une connexion électrique peut aussi relier deux éléments du circuit selon la direction perpendiculaire à la surface du substrat. En particulier, elle peut relier ainsi une borne de contact d'un composant électronique réalisé à la surface du substrat, tel qu'un transistor ou une diode, à une piste située dans la première couche de métallisation. La connexion est alors disposée à travers la couche de prémétallisation. Une connexion électrique peut encore relier deux pistes superposées dans des niveaux de connexions successifs du circuit. Elle est alors appelée via dans le jargon de l'Homme du métier.

Chaque niveau de connexions peut être réalisé en utilisant le procédé Damascène, ou sa variante «dual-Damascène», bien connus de l'Homme du métier.

Chaque niveau de connexions est usuellement défini par une ou deux étapes lithographiques. Chaque étape lithographique met en oeuvre un masque qui définit les emplacements et les dimensions des pistes et/ou des connexions ou vias disposés dans ce niveau. Pour réaliser une connexion entre deux éléments de circuit disposés dans des niveaux distincts, les masques lithographiques utilisés pour chacun des niveaux doivent être précisément alignés par rapport au substrat du circuit, de façon à obtenir des contacts électriques qui présentent de faibles résistances électriques aux extrémités inférieure et supérieure de la connexion. Néanmoins, un décalage peut intervenir involontairement lors de ces alignements, qu'il est nécessaire de prendre en compte pour obtenir des contacts électriques satisfaisants même lorsque l'un des masques lithographiques est décalé par rapport au substrat.

La prise en compte de décalages éventuels des masques lithographiques consiste à prévoir des marges autour des zones de connexion entre des éléments du circuit qui sont superposés dans des niveaux différents. Autrement dit, lors de la conception du circuit, une boîte («enclosure» en anglais) est prévue autour de chaque zone de connexion entre des éléments superposés, afin qu'un contact électrique satisfaisant soit obtenu même si l'un des deux éléments ou la connexion elle-même est décalée par rapport au substrat. Des règles de conception du circuit, appelées règles de dessin, fixent les marges qui doivent être prévues autour des zones de connexion.

Or de telles marges occupent des portions de surface du circuit, parallèlement à la surface du substrat. Elles limitent par conséquent le niveau d'intégration du circuit.

Pour réduire ou supprimer certaines marges dans des niveaux de grilles de transistors, des circuits électroniques intégrés ont été réalisés en laboratoire sur des substrats en verre (2003 IEEE, Proceedings, Akito Hara et al., p. 211). La transparence du substrat vis-à-vis du rayonnement utilisé lors d'une étape lithographique permet d'obtenir deux grilles qui sont alignées l'une par rapport à l'autre, selon la direction perpendiculaire au substrat. Pour cela, l'exposition d'un masque de résine formé sur le circuit à un rayonnement de lumière UV est effectuée à travers le substrat, de sorte qu'une grille inférieure déjà formée sur le circuit constitue un écran opaque qui détermine les dimensions d'une grille supérieure, située d'un côté de la grille inférieure opposé au substrat. Après développement de la résine, le masque présente au moins un bord superposé à un côté de la grille inférieure. Ce bord de masque définit ensuite un côté de la grille supérieure. Aucune marge n'existe alors entre les côtés respectifs des grilles inférieure et supérieure, car un alignement de l'une par rapport à l'autre résulte de l'effet d'écran utilisé lors de l'exposition du circuit au rayonnement du procédé lithographique. Mais il est nécessaire d'utiliser pour cela un substrat transparent au rayonnement du procédé lithographique, ce qui n'est pas le cas d'un substrat de silicium.

Un but de la présente invention consiste donc à réduire les marges nécessaires autour des éléments d'un circuit électronique intégré qui doivent être superposés les uns par rapport aux autres, tout en permettant d'utiliser un substrat de silicium pour le circuit.

Pour cela, l'invention propose un procédé de réalisation de deux éléments superposés au sein d'un circuit électronique intégré, qui comprend les étapes suivantes, le circuit étant élaboré par niveaux successifs à partir d'une surface d'un substrat :
/a/ former au moins un premier élément de circuit dans un premier niveau du circuit, ce premier élément étant réfléchissant pour un rayonnement d'un procédé lithographique ;
/b/ former une première couche au dessus du premier niveau du circuit, dans une première zone du circuit qui contient une première partie du premier élément de circuit et en dehors d'une seconde zone du circuit qui contient une seconde partie du même premier élément de circuit, la première couche étant adaptée pour atténuer un rayonnement réfléchi par le premier élément de circuit ;
/c/ former une seconde couche sensiblement transparente pour ledit rayonnement, de façon à recouvrir le circuit au moins dans la seconde zone ;
/d/ déposer un masque de résine lithographique sur le circuit, dans les première et seconde zones ;
/e/ exposer le masque de résine à un flux primaire de rayonnement correspondant à une quantité de rayonnement inférieure à un seuil de développement du masque de résine, et déterminé de sorte qu'une quantité de rayonnement correspondant à une somme du flux primaire et d'un flux secondaire obtenu par réflexion de ce flux primaire sur la seconde partie du premier élément de circuit est supérieure au seuil de développement du masque de résine ;
/f/ développer le masque de résine de façon à retirer des portions de résine ayant été exposées à une quantité de rayonnement supérieure au seuil de développement ;
/g/ graver les première et seconde couches à travers au moins une ouverture du masque de résine développé ; et
/h/ déposer une portion d'un matériau déterminé pour former un second élément de circuit dans une troisième zone du circuit contenant au moins la seconde partie du premier élément de circuit.

En outre, le second élément de circuit possède au moins un premier côté qui est défini par un bord de la première couche, et au moins un second côté qui est superposé à un bord du premier élément de circuit.

Ainsi, selon l'invention, l'exposition du masque de résine au rayonnement utilisé pour la lithographie comprend deux contributions : d'une part le flux primaire produit par une source du rayonnement externe au circuit et dirigé contre la surface supérieure du circuit, et d'autre part un flux secondaire produit par la réflexion du flux primaire sur le premier élément de circuit, au travers de la première couche et, éventuellement, de la seconde couche. Etant donné que la première couche présente une fonction d'antireflet pour le rayonnement utilisé, le flux secondaire n'existe essentiellement que dans la seconde zone du circuit dépourvue de première couche, au dessus de la seconde partie du premier élément de circuit. Pour cette raison, la première couche peut être désignée par BARC, pour «Bottom AntiReflecting Coating» an anglais. La quantité de rayonnement utilisée pour la lithographique est ajustée pour que le seuil de développement de la résine soit dépassé dans la seconde zone du circuit au dessus du premier élément de circuit, et ne soit pas atteint dans la première zone du circuit. La résine choisie est une résine négative, de sorte que le développement aboutit à un retrait des portions de résine qui ont été exposées à une quantité de rayonnement supérieure au seuil de développement. Le masque de résine présente alors une ouverture au dessus de la seconde partie du premier élément de circuit. Le second élément de circuit, qui est limité parallèlement à la surface du substrat conformément à l'ouverture du masque de résine, est alors exactement superposé à la seconde partie du premier élément de circuit. Autrement dit, les deux éléments de circuit présentent au moins une paire de côtés respectifs qui sont alignés selon la direction perpendiculaire à la surface du substrat. En particulier, le second élément présente au moins une dimension, mesurée parallèlement à la surface du substrat, qui est égale à la dimension correspondante de la seconde partie du premier élément de circuit.

Aucune marge n'est donc présente entre des côtés respectifs des deux éléments de circuit. De telles marges seraient en effet inutiles, puisque le procédé aboutit automatiquement à un alignement du second élément par rapport à la seconde partie du premier élément. Un gain de surface du substrat en résulte, qui permet d'obtenir un niveau supérieur d'intégration du circuit.

L'invention supprime donc la nécessité d'aligner précisément, par rapport au substrat du circuit dans au moins une direction parallèlement à la surface du substrat, un masque de lithographie qui définit la position du second élément de circuit. Une réduction de la durée de fabrication du circuit peut en résulter, d'autant plus importante que le niveau d'intégration du circuit est élevé, car la précision d'alignement qui serait nécessaire sans l'invention est supérieure.

L'invention est donc un perfectionnement du procédé connu de lithographie qui est utilisé pour réaliser des circuits électroniques intégrés. Elle permet de réduire ou de supprimer la nécessité de prévoir des marges d'alignement. Eventuellement, elle peut aussi permettre une mise en oeuvre plus rapide du procédé lithographique.

La seconde partie du premier élément de circuit peut contenir un segment de cet élément, dont une longueur parallèlement à la surface du substrat est déterminée par deux bords opposés de la première couche. Alternativement, la seconde partie du premier élément de circuit peut contenir une extrémité de cet élément selon une direction parallèle à la surface du substrat. Dans ce cas, une longueur de cette extrémité est déterminée par un bord de la première couche.

Eventuellement, la seconde zone du circuit peut contenir plusieurs parties de premiers éléments de circuit formés dans le premier niveau du circuit et réfléchissants pour le rayonnement du procédé lithographique. Autant de parties de seconds éléments de circuit sont alors simultanément réalisées lors d'une même exécution du procédé de l'invention, qui sont superposées respectivement aux parties des premiers éléments de circuit.

Selon un mode de mise en oeuvre particulier de l'invention, une couche absorbante pour le rayonnement du procédé lithographique est disposée dans le premier niveau du circuit autour du ou des premier(s) élément(s) de circuit, ou entre la surface du substrat et le premier niveau du circuit. Le procédé de l'invention est alors compatible avec l'utilisation d'un substrat qui est réfléchissant pour le rayonnement du procédé lithographique.

L'invention peut être appliquée, en particulier, à la réalisation d'une connexion électrique dans un circuit électronique intégré. Dans ce cas, le premier élément de circuit est conducteur électriquement, la seconde couche est isolante électriquement, les première et seconde couches sont gravées à l'étape /g/ jusqu'à découvrir la seconde partie du premier élément de circuit, et le matériau du second élément de circuit est conducteur électriquement de façon à former une connexion électrique reliant le premier élément de circuit.

Le premier élément de circuit peut être, notamment, une piste conductrice disposée dans un niveau de connexions du circuit. Ce niveau de connexions correspond alors à un niveau de métallisation et le second élément de circuit peut être un via.

Alternativement, le premier élément de circuit peut être une borne de contact d'un composant électronique réalisé à la surface du substrat. La connexion électrique s'étend alors à travers le niveau de prémétallisation du circuit perpendiculairement à la surface du substrat.

En outre, la portion de matériau conducteur déposée à l'étape /h/ peut comprendre une première partie s'étendant à partir du premier élément de circuit selon une direction perpendiculaire à la surface du substrat, et une seconde partie formant une piste conductrice disposée dans un second niveau du circuit. Une unique étape de dépôt de matériau conducteur permet alors de réaliser simultanément une connexion électrique reliant le premier élément de circuit selon la direction perpendiculaire à la surface du substrat, et une piste dans le second niveau du circuit.

L'invention propose aussi un circuit électronique intégré comprenant deux éléments de circuit superposés, réalisés en utilisant un procédé tel que décrit précédemment. De tels éléments de circuit présentent des côtés respectifs qui sont alignés selon la direction perpendiculaire à la surface du substrat.

D'autres particularités et avantages de la présente invention apparaîtront dans la description ci-après d'exemples de mise en oeuvre non limitatifs, en référence aux dessins annexés, dans lesquels :
- les figures 1a, 2a, 3a, 4a, 5a et 6a sont des vues en coupe d'un circuit électronique intégré illustrant des étapes successives d'un procédé selon un premier mode de mise en oeuvre de l'invention ;
- les figures 1b, 2b, 3b, 4b et 6b sont des vues de dessus du circuit correspondant respectivement aux figures 1a, 2a, 3a, 4a et 6a ;
- les figures 7a, 7b, 8a, 8b, 9a, 10a et 10b correspondent respectivement aux figures 1a, 1b, 2a, 2b, 3a, 6a et 6b pour un second mode de mise en oeuvre de l'invention ; et
- les figures 11a et 11b sont des vues de dessus d'éléments de mémoire statique à accès aléatoire réalisés respectivement selon l'art antérieur et selon l'invention.

Pour raison de clarté, les dimensions des éléments de circuit représentés sur ces figures ne sont pas en proportion avec leurs dimensions réelles. On désigne par N une direction perpendiculaire aux surfaces de substrats sensiblement plans utilisés pour réaliser les circuits décrits. La direction N est orientée vers le haut des figures qui correspondent à des vues en coupe du circuit, et les mots «sur», «sous», «inférieur» et «supérieur» utilisés dans la suite le sont en référence à cette orientation. D1 et D2 sont des directions parallèles à la surface des substrats, respectivement longitudinale et transversale.

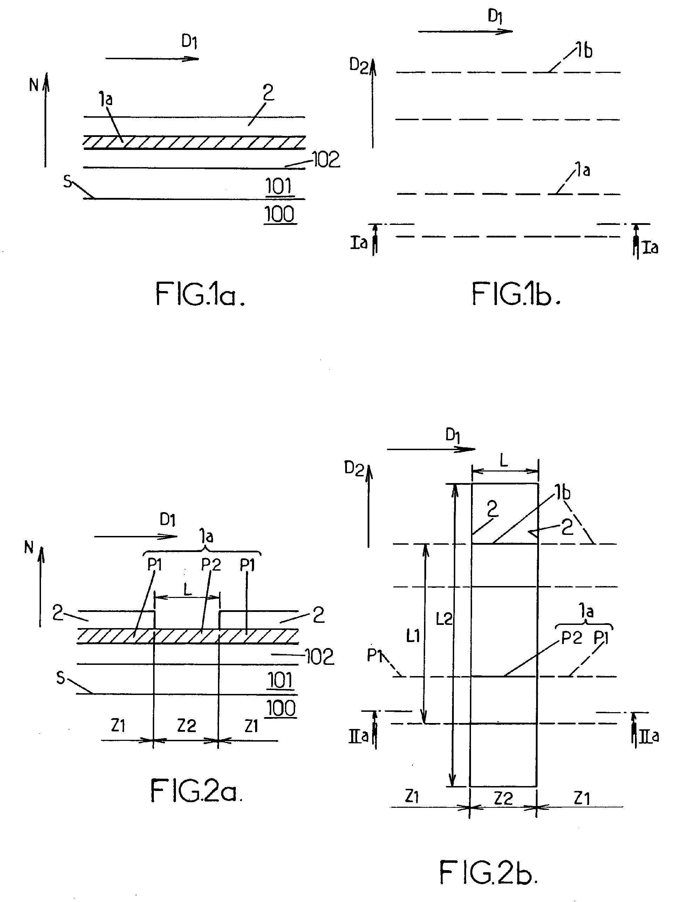

Les figures 1a, 2a, 3a, 4a et 6a sont des vues du circuit dans un plan de coupe indiqué par des flèches sur les figures 1b, 2b, 3b, 4b et 6b.

En outre, des références identiques sur des figures différentes désignent des éléments identiques, ou qui ont des fonctions identiques.

Enfin, on se limite à décrire dans la suite une succession d'étapes élémentaires de réalisation de circuits électroniques intégrés, qui permet de reproduire l'invention. Chaque étape élémentaire, qui est considérée comme connue en soi, n'est pas reprise en détail. L'invention est illustrée dans le cadre de la réalisation de connexions électriques, mais il est entendu qu'elle s'applique à la réalisation d'éléments de circuit quelconques, conducteurs ou isolants électriquement, qui doivent être superposés les uns aux autres.

Conformément aux figures 1a et 1b, un substrat 100 de circuit électronique intégré en cours d'élaboration est recouvert sur sa surface supérieure S d'une couche de prémétallisation 101 et d'au moins une couche de métallisation 102 (figure 1a). Les couches 101 et 102 peuvent être à base de silice (SiO₂), par exemple. Deux pistes métalliques 1a et 1b ont été formées dans la couche 102, par exemple en utilisant le procédé Damascène. Les pistes 1a et 1b sont alors en cuivre (Cu). Alternativement, les pistes 1a et 1b peuvent être en aluminium (Al), en nitrure de titane (TiN), ou en tout autre métal ou alliage conducteur ayant une conductivité électrique suffisante. La couche 102 et les pistes 1a et 1b constituent le premier niveau de métallisation du circuit. La figure 1b montre les deux pistes 1a et 1b, qui sont disposées parallèlement à la direction D1, à titre d'exemple. Il est entendu que toute autre disposition des pistes 1a et 1b à l'intérieur du premier niveau de métallisation du circuit permet de mettre en oeuvre l'invention d'une façon analogue à celle qui est décrite en détail maintenant.

Lorsque le substrat 100 est réfléchissant pour un rayonnement de procédé lithographique destiné à être utilisé pour mettre en oeuvre l'invention, et en particulier lorsque le substrat 100 et en silicium, l'une au moins des deux couches 101 et 102 est sélectionnée pour absorber ce rayonnement. Dans ce cas, le matériau de l'une des couches 101 ou 102 comprend au moins un composé absorbant, en concentration suffisante pour atténuer suffisamment une réflexion du rayonnement produite par le substrat 100.

On dépose alors, sur la couche 102, une couche 2 destinée à atténuer une réflexion d'un rayonnement dirigé contre la surface supérieure du circuit. Cette fonction de la couche 2 sera décrite en détail plus loin. Pour cela, le matériau de la couche 2 produit une absorption du rayonnement, ou présente des propriétés de réfraction telles que la couche 2 disposée entre les pistes 1a, 1b et une partie supérieure du circuit atténue une réflexion du rayonnement sur les pistes 1a et 1b. De telles propriétés de réfraction sont caractérisées de façon connue au moyen d'un indice de réfraction du matériau de la couche 2. La couche 2 peut être constituée, par exemple, d'un mélange de silice et d'un autre composé chimique absorbant pour le rayonnement. Alternativement, l'autre composé chimique peut procurer au matériau de la couche 2 un indice de réfraction supérieur à celui de la silice pure. De préférence, le matériau de la couche 2 est isolant électriquement.

On grave ensuite la couche 2 dans une zone Z2 du circuit : la couche 2 est ainsi retirée dans la zone Z2, et des portions de la couche 2 sont laissées dans une ou plusieurs zones Z1 du circuit (figures 2a et 2b). Les zones Z1 et Z2 du circuit contiennent respectivement des parties P1 et P2 de la piste 1a, ainsi que des parties similaires de la piste 1b. Pour la clarté de l'exposé, le procédé de réalisation d'une connexion électrique selon l'invention est décrit dans ce qui suit pour la piste 1a, mais il est entendu qu'une autre connexion électrique est simultanément réalisée pour la piste 1b. Les figures 1b, 2b, 3b, 4b et 6b illustrent en effet la réalisation de deux connexions électriques disposées respectivement au dessus des deux pistes 1a et 1b. Comme le montre la figure 2b, les zones Z1 et Z2 peuvent être complémentaires par rapport à la surface S, et la dimension L2 de la zone Z2 parallèlement à la direction D2 est plus grande que la largeur de chaque piste 1a, 1b. Dans l'exemple considéré, la dimension L2 est plus grande que la distance L1 entre les bords extérieurs respectifs des pistes 1a et 1b. De cette façon, il n'est pas nécessaire que les limites de la zone Z2 selon la direction D2 soient précisément situées par rapport aux pistes 1a et 1b, tant que ces limites de la zone Z2 ne sont pas décalées jusqu'à atteindre l'un des bords extérieurs des pistes 1a et 1b. Autrement dit, si la zone Z2, dans laquelle la couche 2 est retirée, est définie par un masque de lithographie, ce masque peut être aligné assez rapidement puisqu'un décalage de la zone Z2 parallèlement à la direction D2 est compatible avec le procédé de l'invention.

L désigne la distance entre deux bords opposés de la couche 2, de part et d'autre de la zone Z2 selon la direction D1.

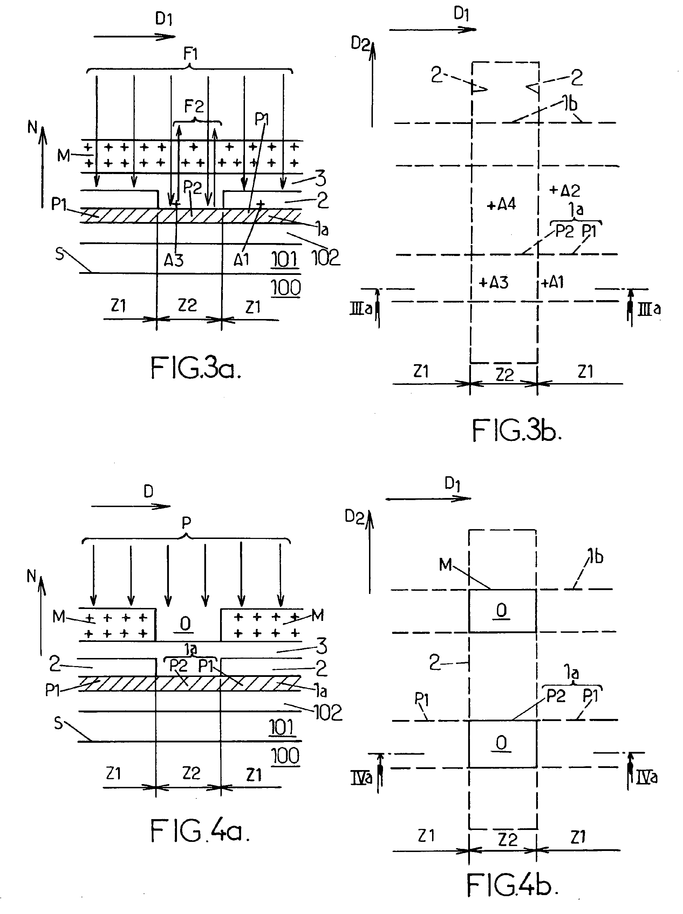

On dépose alors une couche 3 de matériau isolant sur le circuit, de façon à recouvrir le circuit et à remplir la cavité formée par le retrait de la couche 2 dans la zone Z2. La couche 3 est ensuite polie, de sorte que sa face supérieure soit sensiblement plane et parallèle à la surface du substrat S (figure 3a). Elle peut être en silice, par exemple, ou en tout autre matériau qui est essentiellement transparent pour le rayonnement dont une réflexion sur les pistes 1a et 1b est atténuée par la couche 2.

Une couche de résine lithographique M est déposée sur le circuit, au dessus de la couche 3, avec une épaisseur selon la direction N qui est adaptée pour que la couche M forme ultérieurement un masque de gravure.

On irradie ensuite la couche de résine M en dirigeant un faisceau de rayonnement F1 (figure 3a) contre la surface supérieure du circuit, parallèlement à la direction N et en sens opposé à celle-ci. Le faisceau F1 est appelé flux primaire de rayonnement. De préférence, le rayonnement utilisé est une lumière UV, ayant une longueur d'onde adaptée en fonction du type de résine de la couche M. Le flux F1 traverse la couche M et la couche 3, puisque celle-ci est essentiellement transparente.

Dans la zone Z1 du circuit, le flux primaire F1 traverse les couches M et 3, puis atteint la couche 2 et, éventuellement, la piste 1a aux points de la zone Z1 situés sur la partie de piste P1. En un point A1 (figures 3a et 3b) de la zone Z1 qui est situé sur la partie de piste P1, aucun flux réfléchi par cette partie de piste en direction de la surface supérieure du circuit ne traverse de nouveau la couche de résine M, puisque la couche 2 atténue, sinon supprime, une telle réflexion du rayonnement. Simultanément, une partie du flux F1 qui arrive en un point A2 de la zone Z1 situé en dehors de la partie de piste P1 n'engendre pas de flux réfléchi qui émerge de la couche 102, étant donné que l'une au moins des couches 101 et 102 est absorbante si le substrat 100 est réfléchissant. Dans tous les cas, une portion quelconque de la couche de résine M qui est située dans la zone Z1 du circuit ne reçoit qu'une quantité de rayonnement correspondant au flux primaire F1. Cette quantité est ajustée pour être inférieure au seuil de développement du masque de résine M, en choisissant l'intensité du flux F1 et/ou la durée d'exposition.

Dans la zone Z2 du circuit, aucune portion de couche 2 ne recouvre la partie de piste P2. Une partie du flux primaire F1 qui atteint la partie de piste P2 en un point A3 situé au dessus de la partie de piste P2 est donc réfléchi en direction de la surface supérieure du circuit. Le flux de rayonnement produit par cette réflexion est appelé flux secondaire F2. Le flux secondaire F2 traverse alors de nouveau la couche de résine M. Une partie du flux F1 qui arrive en un point A4 de la zone Z2 situé en dehors de la partie de piste P2 n'est pas réfléchi, ni par une piste ni par le substrat 100 à travers les couches 101 et 102. Les bords de la piste 1a qui sont situés dans la zone Z2 définissent donc une limite transversale, selon la direction D2, de l'exposition du masque M au flux secondaire F2.

Par conséquent, seules les portions de la couche de résine M qui sont situées au dessus de parties de pistes 1a, 1b dans la zone Z2 sont traversées par le flux primaire F1 et par le flux secondaire F2. L'intensité du flux primaire F1 et/ou sa durée sont ajustées de sorte que la quantité de rayonnement qui correspond à la somme des flux F1 et F2 est supérieure au seuil de développement de la couche de résine M.

On développe la couche de résine M, d'une façon connue, par exemple en utilisant un bain de dissolution. La résine étant de type résine négative, les portions de la couche de résine M qui ont été exposées à une quantité de rayonnement correspondant à F1+F2 sont éliminées, alors que les portions de la couche M qui ont été exposées à une quantité de rayonnement correspondant seulement au flux F1 subsistent. Ainsi, à l'issue du développement, la couche M présente des ouvertures O seulement au dessus des parties de pistes P2 situées dans la zone Z2 (figures 4a et 4b). Autrement dit, la couche M forme un masque qui recouvre le circuit sélectivement en dehors des parties de pistes P2. Pour cette raison, elle est appelée masque M.

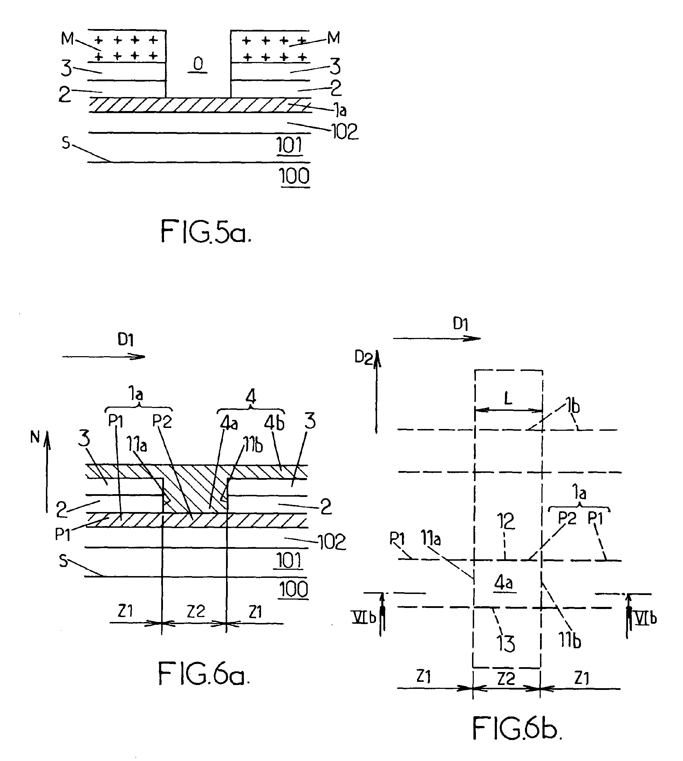

On grave alors la couche 3 à travers le masque M en utilisant un plasma de gravure P, dirigé contre la surface supérieure du circuit, parallèlement à la direction N et en sens opposé à celle-ci. Un tel procédé de gravure est couramment désigné par gravure sèche. L'extension de la gravure, parallèlement à la surface S, est déterminée par l'ouverture O du masque M. La couche 3 est ainsi éliminée au dessus de la partie de piste P2, jusqu'à découvrir la surface supérieure de la partie de piste P2 (figure 5a).

Le masque de résine M est alors entièrement retiré.

On dépose ensuite une couche métallique 4 sur le circuit (figures 6a et 6b), de façon à remplir la cavité formée au dessus de la partie de piste P2 par la gravure de la couche 3. La couche 4 peut être à base de cuivre, d'aluminium ou de nitrure de titane, par exemple. Elle comprend une partie 4a qui s'étend jusqu'à la piste 1a selon la direction N, au dessus de la partie P2 de celle-ci. Cette partie 4a constitue une connexion électrique, ou via 4a, qui relie la piste 1a à travers les couches 2 et 3. Les positions respectives des côtés 11a et 11b de ce via, qui sont parallèles à la direction D2, sont déterminées par la gravure de la couche 2 illustrée par les figures 2a et 2b. Les côtés 12 et 13 du via 4a, qui sont parallèles à la direction D1, sont superposés aux bords de la piste 1a dans la zone Z2, étant donné que ces bords de piste définissent une limite d'exposition du masque M au flux secondaire de rayonnement F2. Autrement dit, les côtés 12 et 13 du via 4a sont alignés avec les côtés longitudinaux de la piste 1a, selon la direction N.

Eventuellement, la couche métallique 4 peut aussi comprendre une partie 4b qui s'étend parallèlement à la surface S, sur la couche 3. Une telle partie 4b peut constituer une piste dans un second niveau de métallisation du circuit correspondant aux couches 2, 3 et 4. La piste 4b est alors formée simultanément au via 4a.

Dans le premier exemple de mise en oeuvre de l'invention qui vient d'être décrit, la partie de piste P2 correspond à un segment de la piste 1a de longueur L. Cette longueur L est déterminée par deux bords opposés de la couche 2.

On décrit maintenant, en référence aux figures 7a-10b, un second exemple de mise en oeuvre de l'invention, suivant lequel la partie de piste P2 correspond à une extrémité de la piste 1a.

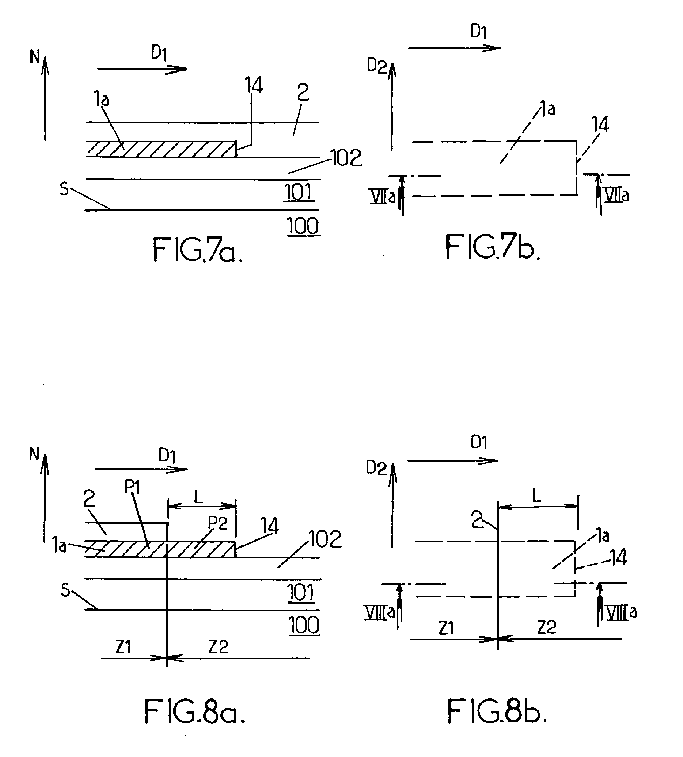

Les figures 7a et 7b correspondent respectivement aux figures 1a et 1b pour un élément de circuit constitué d'une extrémité de piste. La piste 1a s'étend sur la couche isolante 102 parallèlement à la direction D1, et se termine par une extrémité ayant un côté 14 perpendiculaire à la direction D1.

Une couche 2 est encore déposée sur le circuit et polie sur sa surface supérieure (figure 7a). Elle est ensuite gravée dans une zone Z2 du circuit de façon à découvrir la piste 1a sur une longueur L à partir du côté 14, mesurée parallèlement à la direction D1 (figures 8a et 8b). La zone Z2 s'étend au delà du côté 14 dans le sens de la direction D1, et de part et d'autre de l'extrémité de la piste 1a selon la direction D2. La partie de piste 1a qui reste recouverte de couche 2 correspond à la partie P1 du premier mode de mise en oeuvre de l'invention, et l'extrémité découverte de la piste 1a correspond à la partie P2. La zone Z1 est complémentaire à la zone Z2 et contient la partie de piste P1.

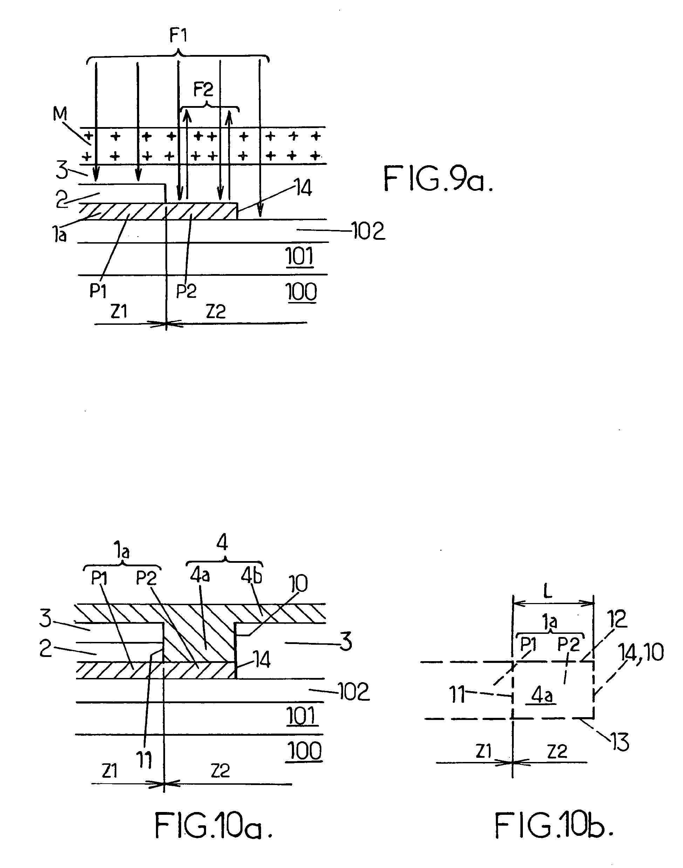

La réalisation du circuit est poursuivie d'une façon identique à celle du premier mode de mise en oeuvre de l'invention. En particulier, une couche 3 est formée sur le circuit, puis polie pour obtenir une surface supérieure de la couche 3 sensiblement plane et parallèle à la surface S du substrat 100 (figure 9a). Les matériaux des couches 2 et 3 sont choisis de la même façon que celle décrite précédemment. Un masque de résine M est formé sur le circuit, puis exposé à un flux de rayonnement F1. L'intensité du flux F1 est choisie de sorte que des portions de résine situées dans la zone Z1 sont exposées à une quantité de rayonnement inférieure au seuil de développement de la résine. Elle est choisie en outre de sorte que des portions de résine situées au dessus de l'extrémité P2 de la piste 1a dans la zone Z2 sont exposées à une quantité de rayonnement supérieure au seuil de développement de la résine, grâce à un flux supplémentaire de rayonnement F2 produit par la réflexion du flux F1 sur l'extrémité P2 de la piste 1a, qui n'est pas recouverte de couche 2.

La résine étant négative, le développement du masque M aboutit à un retrait du masque uniquement au dessus de l'extrémité P2 de la piste 1a. La couche 3 n'est alors gravée qu'à cet endroit, et un via 4a est obtenu, qui possède trois côtés 10, 12 et 13 superposés respectivement aux côtés de l'extrémité P2 de la piste 1a. Un quatrième côté 11 du via 4a est défini par le bord de la couche 2, qui marque la limite entre les zones Z1 et Z2 (figures 10a et 10b). Le via 4a est donc superposé exactement à l'extrémité P2 de la piste 1a. Il possède une longueur L parallèlement à la direction D2, qui correspond à la distance entre le bord de la couche 2 et le côté 14 de l'extrémité P2 de la piste 1a.

Les deux exemples de mise en oeuvre de l'invention qui viennent d'être décrits correspondent à la réalisation d'un via à travers une couche de métallisation d'un circuit. Il est entendu que l'invention peut être appliquée identiquement pour réaliser une connexion électrique à travers une couche de prémétallisation d'un circuit. Dans ce cas, la piste 1a est remplacée par une borne de contact d'un composant électronique du circuit réalisé au niveau de la surface S. Une telle borne peut être une zone de contact de grille, de drain ou de source d'un transistor MOS, par exemple.

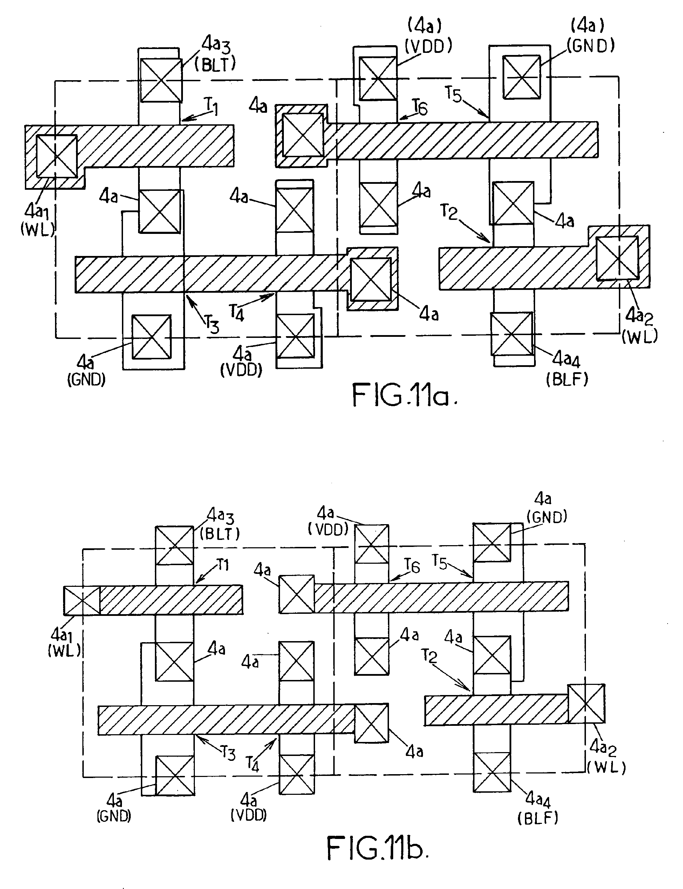

Le circuit auquel l'invention est appliquée peut comprendre une cellule de mémoire statique à accès aléatoire, ou SRAM (pour «Static Random Access Memory» en anglais) à six transistors MOS. Les figures 11a et 11b représentent des configurations de telles cellules SRAM réalisées à la surface de substrats semiconducteurs. La cellule SRAM à six transistors est prise à titre d'exemple, mais il est entendu que l'invention peut être mise en oeuvre quelque soit la fonction du circuit. La structure d'une cellule SRAM est considérée connue. On rappelle seulement qu'elle est constituée de deux transistors d'accès T1 et T2, et de deux inverseurs constitués chacun de deux transistors MOS, respectivement T3, T4 pour le premier inverseur et T5, T6 pour le second inverseur de la cellule. Une entrée de chaque inverseur est connectée à une sortie de l'autre inverseur (non représenté sur les figures 11a et 11b), de façon à constituer un système bistable. L'état de ce système peut être changé en plaçant les transistors d'accès T1 et T2 dans un état passant, et en appliquant simultanément un signal électrique approprié sur des bornes d'écriture de la cellule SRAM.

Les connexions 4a₁ et 4a₂ relient respectivement des grilles des transistors d'accès T1 et T2 à une ligne de mot WL. Les connexions 4a₃ et 4a₄ relient respectivement des zones de source des transistors d'accès T1 et T2 à deux lignes de bit complémentaires notées BLT et BLF. Elles constituent les bornes d'écriture de la cellule SRAM. D'autres connexions de la cellule SRAM, référencées 4a d'une façon générique, relient des zones de contact de sources, de drains ou de grilles des transistors de la cellule entre elles ou à des lignes d'alimentation de la cellule notées GND ou VDD. Les lignes WL, BLT, BLF, GND et VDD sont indiquées entre parenthèses après les références des connexions correspondantes.

La figure 11a montre une réalisation d'une cellule SRAM à six transistors, telle que connue de l'art antérieur. Des marges sont nécessaires sur certains côtés des zones de contact de sources, de grilles et de drains des transistors, autour des connexions 4a, 4a₁-4a₄, pour prendre en compte d'éventuels décalages entre ces connexions et les transistors T1-T6. Les dimensions de la cellule dans un plan parallèle à la surface du substrat sont 1290 nm (nanomètres) x 540 nm, pour la technologie dite de 90 nm de réalisation des transistors MOS.

La figure 11b correspond à la figure 11a, pour une cellule SRAM du même type mais réalisée en utilisant l'invention. La cellule SRAM de la figure 11b est encore réalisée en utilisant la technologie de 90 nm. Grâce à l'invention, certaines des marges des zones de contact des transistors T1-T6 peuvent être supprimées, et d'autres réduites. Les dimensions de la cellule SRAM sont alors 1170 nm x 460 nm, ce qui représente un gain de 23% de surface du substrat par rapport à la cellule SRAM de la figure 11a.

L'Homme du métier comprendra que l'invention peut être mise en oeuvre quelque soit la technologie utilisée pour la réalisation de transistors MOS, correspondant à des longueurs de grilles de 90 nm, 65 nm, 45 nm ou moins.

Enfin l'invention peut être mise en oeuvre pour tout type d'éléments de circuit destinés à être superposés au dessus de la surface d'un substrat. Outre une piste conductrice et une zone de contact d'un transistor MOS, un tel élément peut être une zone contact d'un transistor bipolaire, une zone de contact de diode, de condensateur, de résistance ou d'inductance, en particulier.

## Revendications

1. Procédé de réalisation de deux éléments superposés au sein d'un circuit électronique intégré élaboré par niveaux successifs à partir d'une surface (S) d'un substrat (100) du circuit, le procédé comprenant les étapes suivantes :
/a/ former au moins un premier élément de circuit (1a) dans un premier niveau du circuit, ledit premier élément étant réfléchissant pour un rayonnement d'un procédé lithographique (F1) ;
/b/ former une première couche (2) au dessus du premier niveau du circuit, dans une première zone du circuit (Z1) contenant une première partie (P1) du premier élément de circuit (1a) et en dehors d'une seconde zone du circuit (Z2) contenant une seconde partie (P2) dudit premier élément (1a), ladite première couche étant adaptée pour atténuer un rayonnement réfléchi par le premier élément de circuit (F2) ;
/c/ former une seconde couche (3) sensiblement transparente pour ledit rayonnement, de façon à recouvrir le circuit au moins dans ladite seconde zone (Z2) ;
/d/ déposer un masque de résine lithographique (M) sur le circuit, dans les première (Z1) et seconde (Z2) zones ;
/e/ exposer le masque de résine (M) à un flux primaire de rayonnement (F1) correspondant à une quantité de rayonnement inférieure à un seuil de développement du masque de résine, et déterminé de sorte qu'une quantité de rayonnement correspondant à une somme dudit flux primaire (F1) et d'un flux secondaire (F2) obtenu par réflexion dudit flux primaire sur la seconde partie du premier élément de circuit (P2) est supérieure au seuil de développement du masque de résine ;
/f/ développer le masque de résine (M) de façon à retirer des portions de résine ayant été exposées à une quantité de rayonnement supérieure au seuil de développement ;
/g/ graver les première (2) et seconde (3) couches à travers au moins une ouverture du masque de résine développé (M) ; et
/h/ déposer une portion (4) d'un matériau déterminé pour former un second élément de circuit (4a) dans une troisième zone du circuit contenant au moins la seconde partie du premier élément de circuit (P2),
le procédé étant **caractérisé en ce que** le second élément de circuit (4a) possède au moins un premier côté (11, 11a, 11b) défini par un bord de ladite première couche (2), et au moins un second côté (10, 12, 13) superposé à un bord du premier élément de circuit (1a).

2. Procédé selon la revendication 1, suivant lequel la seconde zone du circuit (Z2) contient plusieurs parties de premiers éléments de circuit formés dans le premier niveau du circuit et réfléchissants pour le rayonnement du procédé lithographique.

3. Procédé selon la revendication 1 ou 2, suivant lequel la seconde partie du premier élément de circuit (P2) contient un segment dudit premier élément, une longueur dudit segment (L) parallèlement à la surface du substrat (S) étant déterminée par deux bords opposés de la première couche (2).

4. Procédé selon la revendication 1 ou 2, suivant lequel la seconde partie du premier élément de circuit (P2) contient une extrémité dudit premier élément selon une direction parallèle à la surface du substrat (D1), ladite extrémité ayant une longueur (L) déterminée par un bord de la première couche (2).

5. Procédé selon l'une quelconque des revendications précédentes, suivant lequel une couche absorbante (101, 102) pour le rayonnement du procédé lithographique est déposée dans le premier niveau du circuit autour du premier élément de circuit (1a), ou entre la surface du substrat (S) et le premier niveau du circuit.

6. Procédé selon l'une quelconque des revendications précédentes, suivant lequel :
- le premier élément de circuit (1a) est conducteur électriquement ;
- la seconde couche (3) est isolante électriquement ;
- les première (2) et seconde (3) couches sont gravées à l'étape /g/ jusqu'à découvrir la seconde partie du premier élément de circuit (P2) ; et
- le matériau du second élément de circuit (4a) est conducteur électriquement de façon à former une connexion électrique reliant le premier élément de circuit (1a).

7. Procédé selon la revendication 6, suivant lequel le premier élément de circuit (1a) comprend une piste conductrice disposée dans un niveau de connexions du circuit.

8. Procédé selon la revendication 6, suivant lequel le premier élément de circuit (1a) comprend une borne de contact d'un composant électronique réalisé à la surface du substrat (S).

9. Procédé selon l'une quelconque des revendications 6 à 8, suivant lequel la portion de matériau conducteur (4) déposée à l'étape /h/ comprend une première partie (4a) s'étendant à partir du premier élément de circuit (1a) selon une direction (N) perpendiculaire à la surface du substrat (S), et une seconde partie (4b) formant une piste conductrice disposée dans un second niveau du circuit.

10. Circuit électronique intégré comprenant deux éléments de circuit superposés (1a, 4a), réalisés en utilisant un procédé selon l'une quelconque des revendications précédentes, et présentant des côtés respectifs (10, 12, 13, 14) alignés selon une direction (N) perpendiculaire à la surface du substrat (S).

11. Circuit électronique selon la revendication 10, comprenant une cellule de mémoire statique à accès aléatoire.
